(19) Europäisches Patentamt

European Patent Office

Office européen des brevets

(11) **EP 0 637 848 B1**

(12) **FASCICULE DE BREVET EUROPEEN**

(45) Date de publication et mention
de la délivrance du brevet:
**22.11.2000 Bulletin 2000/47**

(51) Int. Cl.⁷: **H01L 29/74**, H05B 41/04

(21) Numéro de dépôt: **94410063.5**

(22) Date de dépôt: **03.08.1994**

(54) **Thyristor à amplification de gâchette à courant de maintien accru**

Thyristor mit Hilfsemitterelektrode mit erhohtem Haltestrom

Amplifying gate thyristor with increased holding current

(84) Etats contractants désignés:
**DE FR GB IT**

(30) Priorité: **06.08.1993 FR 9309929**

(43) Date de publication de la demande:
**08.02.1995 Bulletin 1995/06**

(73) Titulaire:
**STMicroelectronics S.A.
94250 Gentilly (FR)**

(72) Inventeurs:
• **Bernier, Eric
F-37000 Tours (FR)**

• **Berthiot, Denis
F-37000 Tours (FR)**

(74) Mandataire: **de Beaumont, Michel
1bis, rue Champollion
38000 Grenoble (FR)**

(56) Documents cités:
**EP-A- 0 118 309      EP-A- 0 214 027
EP-A- 0 249 485      DE-A- 2 447 621
FR-A- 2 377 095      US-A- 3 942 070**

• **PATENT ABSTRACTS OF JAPAN vol. 6, no. 259
(E-149) (1137) 17 Décembre 1982 & JP-A-57 157
571 (MEIDENSHA K.K) 29 Septembre 1982**

## Description

La présente invention concerne le domaine des commutateurs du type thyristor qui peuvent être mis en conduction quand une tension de polarité convenable existe à leurs bornes et qu'une impulsion est appliquée sur leur gâchette et qui restent ensuite en conduction tant qu'une tension de polarité appropriée est appliquée à leurs bornes. La présente invention concerne plus particulièrement les thyristors à amplification de gâchette qui présentent l'avantage de pouvoir être commandés par un courant de déclenchement faible.

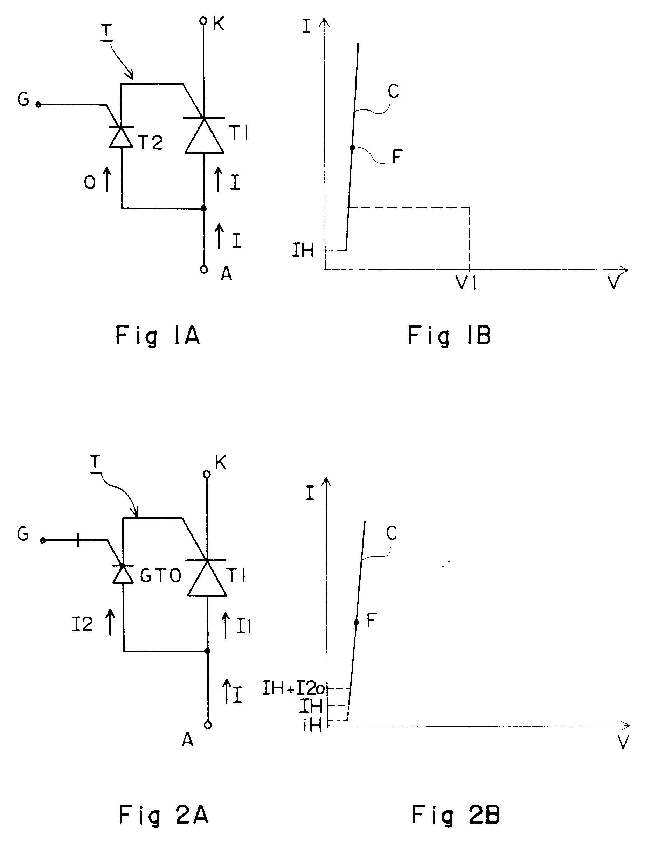

La figure 1A représente schématiquement sous forme de circuit un thyristor à amplification de gâchette. Ce composant T a une anode A et une cathode K qui correspondent à l'anode et à la cathode d'un thyristor principal T1. Ce thyristor principal est associé à un thyristor amplificateur T2 dont l'anode est connectée à la borne A et dont la cathode est connectée à la gâchette du thyristor T1. La gâchette du thyristor T2 constitue la borne de commande G du thyristor à amplification de gâchette.

La figure 1B représente l'allure de la caractéristique courant-tension d'un thyristor à amplification de gâchette (ou d'ailleurs d'un thyristor classique).

Si, tandis qu'une tension V1 est appliquée entre l'anode et la cathode d'un thyristor, une impulsion est appliquée sur la gâchette G, le thyristor entre en conduction, c'est-à-dire que, dans un premier temps, son courant croît à tension sensiblement constante et que, dans un deuxième temps, la tension chute rapidement. Alors, le point de fonctionnement F se déplace sur une courbe caractéristique C qui est une courbe presque verticale correspondant à une faible chute de tension aux bornes du thyristor. Par exemple, si l'impulsion de gâchette a été appliquée au début d'une alternance positive d'un signal périodique, on aura d'abord une croissance du courant puis une décroissance de celui-ci. Quand le point de fonctionnement F atteint une valeur minimale correspondant à un courant $I_H$ (courant de maintien) le thyristor se désamorce et revient à l'état bloqué. Il faut alors lui réappliquer une tension de gâchette pour le remettre en conduction, à condition aussi que le circuit soit apte à faire alors passer un courant dans ce thyristor supérieur au courant de maintien.

Dans certaines applications des thyristors à amplification de gâchette, on cherche à avoir une valeur élevée du courant $I_H$, c'est-à-dire une coupure du thyristor tandis que le courant qui le traverse décroît et a encore une valeur relativement importante.

Dans l'état actuel de la technique, SGS-Thomson Microelectronics commercialise sous la référence TN22 un thyristor commandable par un courant de gâchette de 1,5 mA ayant une tension d'avalanche de 1000 à 1600 V et un courant de maintien supérieur à 175 mA.

Parmi les caractéristiques nécessaires à l'obtention d'un courant de maintien élevé, il est connu qu'il convient que la zone de cathode du thyristor comprenne une densité de trous de court-circuit d'émetteur relativement élevée. On pourra donc en utilisant les techniques classiques concevoir un thyristor T1 propre à avoir un courant de maintien relativement élevé. On ne peut toutefois pas faire croître indéfiniment la densité de trous de court-circuit et donc la valeur du courant de maintien. En effet, une augmentation de la densité de trous de court-circuit correspond en particulier à une augmentation du courant d'amorçage du thyristor et de sa chute de tension à l'état passant. Le thyristor risquerait donc de ne plus pouvoir être amorcé et de ne pouvoir supporter le passage de courants importants.

En ce qui concerne le thyristor amplificateur T2, qui doit être un thyristor sensible pour permettre un déclenchement à faible courant de commande du thyristor à amplification de gâchette, ce thyristor T2 aura inévitablement un courant de maintien relativement faible. Ainsi, quand on réalise un thyristor à amplification de gâchette qui doit avoir un courant de maintien relativement élevé, le concepteur de circuit utilise diverses techniques classiques pour que, une fois que le thyristor T2 s'est amorcé et a provoqué l'amorçage du thyristor T1, ce thyristor T1 reste seul conducteur et que le thyristor T2 se désamorce, c'est-à-dire que, une fois que le thyristor T1 se sera amorcé, il sera suffisamment conducteur par rapport au thyristor T2 pour que le courant dans celui-ci devienne inférieur à son faible courant de maintien.

Ainsi, comme cela est illustré dans la figure 1A, une fois le courant établi dans le composant T, le courant d'anode I passera entièrement dans le thyristor principal T1 et le courant dans le thyristor amplificateur T2 sera nul. En conséquence, au voisinage d'une zone de désamorçage, seul entrera en compte le courant de maintien élevé du thyristor T1 puisque le thyristor T2 est déjà désamorcé.

Comme on l'a indiqué précédemment, pour un thyristor de dimension donnée, il existe une limite à la possibilité d'augmenter la valeur du courant de maintien sans nuire à d'autres caractéristiques du thyristor.

Ainsi, un objet de la présente invention est de prévoir un thyristor à amplification de gâchette qui puisse être ouvert pour un courant le traversant supérieur à celui d'un thyristor à amplification de gâchette classique ayant sensiblement la même structure.

Un autre objet de la présente invention est de prévoir un tel thyristor à amplification de gâchette qui soit réalisable sans modification technologique par rapport à la réalisation d'un thyristor à amplification de gâchette classique.

Pour atteindre cet objet, la présente invention prévoit un thyristor à amplification de gâchette dans lequel le thyristor amplificateur est du type à ouverture par la gâchette (GTO) et dans lequel le thyristor principal et le thyristor amplificateur sont réalisés de sorte que le thyristor amplificateur reste en conduction tant que le thyristor principal est en conduction normale.

Selon un mode de réalisation de la présente invention, le thyristor est réalisé sous forme d'un composant monolithique dans lequel le thyristor principal et le thyristor amplificateur sont réalisés verticalement dans une structure semiconductrice.

Selon un mode de réalisation de la présente invention, le thyristor principal et le thyristor amplificateur ont des niveaux de dopage d'émetteur et/ou de cathode distincts.

Selon un mode de réalisation de la présente invention, le courant dans le thyristor amplificateur a une valeur déterminée quand le courant dans le thyristor principal est proche du courant de maintien de celui-ci, et il est prévu des moyens pour détecter le moment où le courant total dans le thyristor chute à une valeur sensiblement voisine de la somme dudit courant de maintien et dudit courant de valeur déterminée et des moyens pour appliquer une tension de gâchette négative sur le thyristor à ouverture par la gâchette quand cette détection a été réalisée.

Une application d'une structure selon la présente invention réside dans les commutateurs associés à des ballasts de lampes à fluorescence alimentés par du courant alternatif redressé qui doivent, sur commande, être ouverts tandis que le courant qui les traverse a une valeur relativement élevée de façon à provoquer une rupture brutale d'alimentation d'une charge inductive et la création d'une surtension. Un circuit de commutateur associé à des ballasts de lampe à fluorescence est décrit dans la demande de brevet européen 118 309.

Dans le cadre de cette application le thyristor selon l'invention est connecté aux bornes continues d'un pont redresseur, en série avec une chaîne de diodes, avec une résistance entre gâchette et anode et un interrupteur commandé entre la gâchette du thyristor et la cathode de la dernière diode de la chaîne de diodes, la valeur de la somme du courant de maintien du thyristor principal et du courant dans le thyristor amplificateur étant supérieure au courant dans le thyristor pendant la phase de préchauffage de la lampe à fluorescence.

Ces objets, caractéristiques et avantages ainsi que d'autres de la présente invention seront exposés en détail dans la description suivante de modes de réalisation particuliers faite en relation avec les dessins joints parmi lesquels :

les figures 1A et 1B décrites précédemment conoernent un thyristor à amplification de gâchette classique ;
les figures 2A et 2B représentent le schéma de circuit d'un thyristor à amplification de gâchette selon la présente invention et sa courbe caractéristique courant-tension ;
la figure 3 représente une vue en coupe schématique d'un premier mode de réalisation d'un thyristor à amplification de gâchette selon la présente invention ;
la figure 4 représente une vue en coupe schématique d'un deuxième mode de réalisation d'un thyristor à amplification de gâchette selon la présente invention ;
la figure 5 représente une vue de dessus schématique d'un mode de réalisation d'un thyristor à amplification de gâchette selon la présente invention ;
la figure 6 représente une variante de réalisation de la zone de gâchette du thyristor amplificateur GTO utilisable dans la représentation de la figure 5 ;
la figure 7 représente un schéma connu d'utilisation du thyristor de la figure 1A ; et
la figure 8 représente un schéma d'utilisation d'un thyristor selon la présente invention.

Comme le représente la figure 2A, la présente invention prévoit, dans un thyristor à amplification de gâchette T du type de celui de la figure 1A, de remplacer le thyristor amplificateur T2 par un thyristor du type à ouverture par la gâchette GTO. En outre, les structures des thyristors T1 et GTO sont choisies pour que, quand le thyristor T1 est à l'état passant, la tension à ses bornes reste suffisante pour que le courant dans le thyristor GTO reste supérieur au courant de maintien $i_H$ de ce thyristor GTO. Ainsi, quand le composant est à l'état passant, le courant I dans son anode se divise en un courant I1 dans le thyristor principal T1 et un courant I2 dans le thyristor amplificateur GTO, le courant I1 étant bien entendu nettement supérieur au courant I2 quand le thyristor T1 est en pleine conduction.

Le courant de maintien du thyristor à amplification de gâchette dans son ensemble correspondra au courant de maintien $i_H$ du GTO qui, comme cela a été précédemment expliqué dans le cas du thyristor amplificateur T2, correspond à une valeur faible, nettement inférieure à la valeur du courant de maintien $I_H$ du thyristor principal T1.

Quand le courant principal I dans le composant selon l'invention décroît et atteint une valeur telle que le courant I1 dans le thyristor T1 est voisin du courant de maintien $I_H$ de ce thyristor considéré isolément, il circule un courant $I2_0$ dans le thyristor GTO. Par définition, un thyristor à ouverture par la gâchette peut être interrompu si l'on impose sur sa gâchette une tension inférieure à la tension sur sa cathode, c'est-à-dire que la tension sur la borne G est inférieure à la tension sur la borne K, d'une valeur correspondant sensiblement à deux à trois chutes de tension en direct de diodes (1,4 à 2,1 volts). Alors, le courant $I2_0$ pourra être absorbé par le circuit de gâchette et le thyristor GTO se désamorcera. Simultanément, le thyristor T1 qui est parcouru par un courant légèrement inférieur à son courant de maintien normal se désamorcera. On obtient ainsi un composant susceptible de se désamorcer pour une valeur du courant d'ensemble égale à $I_H+I2_0$.

On aura ainsi obtenu, au prix d'une légère modification du composant de la figure 1A et moyennant la prévision d'un circuit de commande d'ouverture simple de la gâchette du thyristor GTO, un composant dont le courant de maintien apparent ($I_H+I2_0$, voir figure 2B) est supérieur au tension de maintien d'un thyristor de mêmes caractéristiques générales dans lequel le thyristor amplificateur est un thyristor classique non ouvrable par la gâchette.

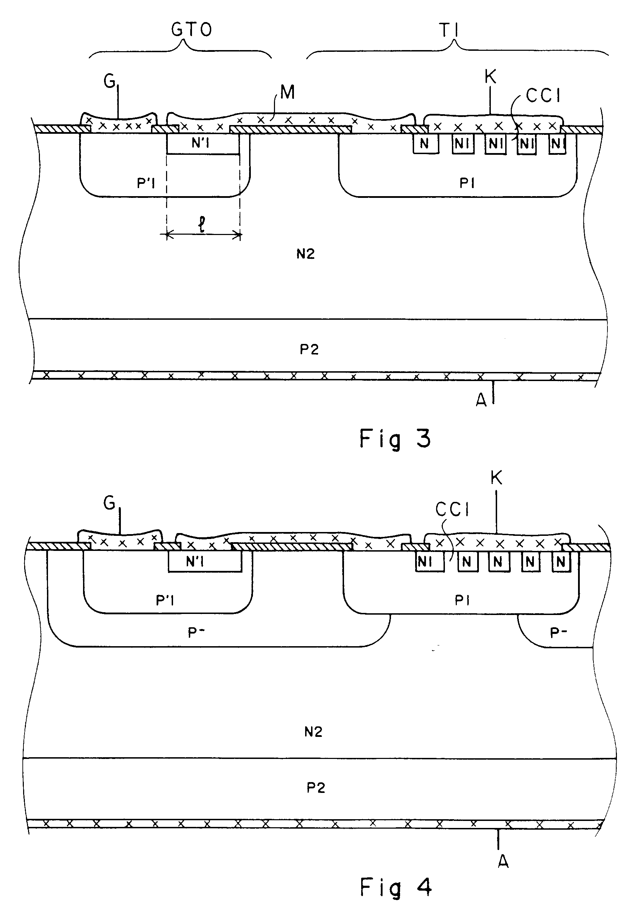

La figure 3 représente une vue en coupe schématique d'une réalisation monolithique d'un thyristor à amplification de gâchette selon la présente invention.

Le thyristor principal T1 est formé verticalement dans une plaquette semiconductrice et comprend des couches successives N1, P1, N2 et P2. La région N1 est formée sur la face supérieure de la plaquette et correspond à la cathode. La région P1, couramment appelée région d'émetteur, constitue un caisson formé dans un substrat N2, et la couche d'anode P2 correspondant à une couche de face arrière. De façon classique, la région N1 est interrompue de sorte que des portions de la couche P1 remontent localement au niveau de la surface supérieure du composant dans des trous CC1 formés dans oette région N1, trous couramment appelés courts-circuits d'émetteur. La surface apparente de la couche N1 et des courts-circuits d'émetteur est revêtue d'une métallisation K. La face arrière est revêtue d'une métallisation A.

Le thyristor amplificateur GTO est constitué de régions N'1, P'1, N2 et P2. Les régions N2 et P2 sont les mêmes que celles mentionnées précédemment et la région P'1 est un caisson formé comme le caisson P1 dans le substrat N2. La région N'1 constitue la cathode du thyristor amplificateur et la région P'1 sa zone d'émetteur ou de gâchette. La métallisation d'anode A du thyristor principal constitue également la métallisation d'anode du thyristor amplificateur. La région N'1 est reliée par une métallisation flottante M à la surface supérieure de la région P1 et la surface supérieure de la région P'1 est revêtue d'une métallisation G qui constitue la gâchette du composant.

La description qui précède s'applique aussi à un thyristor à amplification de gâchette classique. Pour que le thyristor amplificateur ait les caractéristiques d'un thyristor ouvrable par la gâchette, il convient que ce thyristor GTO présente une configuration spécifique de la région N'1 dans le caisson P'1. Des configurations adaptées sont connues en elles-mêmes. Il convient essentiellement que la largeur 1 de la cathode N'1, c'est-à-dire la distance entre un point de cette cathode le plus éloigné de la métallisation de gâchette et un point de cette cathode le plus proche de la métallisation de gâchette, soit faible. En effet, pour pouvoir extraire du courant par la métallisation de gâchette G, et que la circulation de courant dans la région N'1 cesse, il faut que le courant circulant de l'extrémité la plus éloignée à l'extrémité la plus proche de cette largeur 1 n'entraîne pas sous la cathode une chute de tension supérieure à la chute de tension en direct d'une diode.

Bien entendu, la structure selon la présente invention est susceptible de toutes les modifications et variantes habituellement apportées à la réalisation des thyristors à ouverture par la gâchette et des thyristors à amplification de gâchette.

Une telle variante est illustrée en figure 4 dans laquelle de mêmes références qu'en figure 3 désignent de mêmes couches mais où on a rajouté une région P⁻ entourant complètement le caisson P'1 et la périphérie du caisson P1. De façon connue, une telle structure permet d'obtenir un thyristor supportant des tensions plus élevées. Par exemple, si le thyristor de la figure 3 a été conçu pour supporter une tension de l'ordre de 700 volts, le thyristor de la figure 4 pourra supporter une tension de l'ordre de 1500 volts.

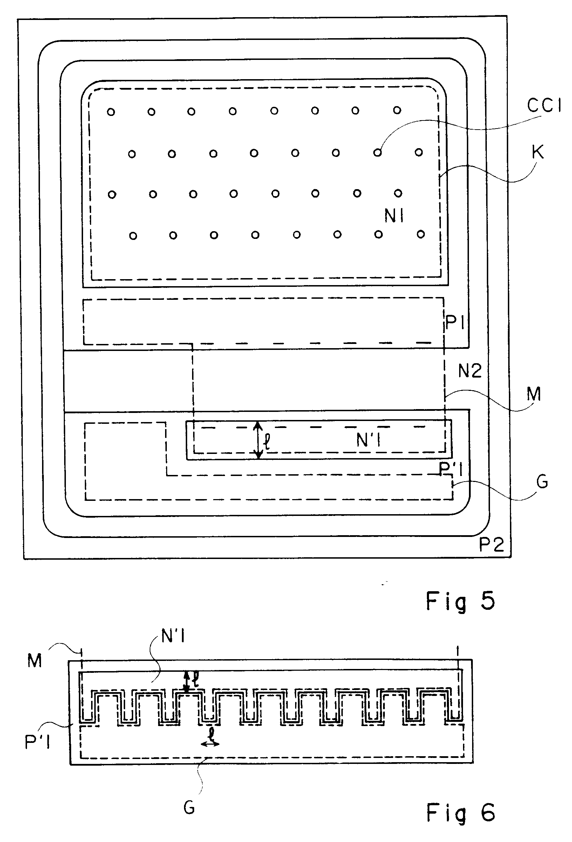

La figure 5 représente un exemple de vue de dessus d'un thyristor à amplification de gâchette selon la présente invention. Cette vue de dessus ne correspond pas à la vue en coupe de la figure 3 mais de mêmes couches y sont désignées par de mêmes références. Dans cette figure, on a représenté un thyristor du type à caisson, c'est-à-dire un thyristor dans lequel la périphérie est occupée par une région P, désignée par la référence P2 puisqu'elle rejoint la couche P2 de face arrière. Dans le substrat N2 qui apparaît à l'intérieur de la région périphérique P2 sont formés les deux caissons P1 et P'1 et, à l'intérieur de chacun de ces caissons, les régions de cathode N1 et N'1. Les contours des métallisations K, G et M sont désignés par des traits en pointillés. Bien entendu, la partie de la métallisation M qui s'étend au-dessus de la région N2 est isolée par une couche isolante, couramment une couche d'oxyde de silicium, de la surface apparente de la couche N2. Cette couche isolante et d'autres sont représentées symboliquement par des couches minces hachurées en figures 3 et 4.

La figure 6 représente une variante de réalisation des régions de gâchette et de cathode du thyristor à amplification de gâchette GTO. Dans cette variante, la frontière des régions de cathode et de gâchette est interdigitée.

Comme cela a été représenté, et de façon classique, la cathode du thyristor amplificateur GTO n'est pas munie de courts-circuits d'émetteur tandis que celle du thyristor principal comprend des courts-circuits d'émetteur CC1. La répartition et la densité de ces courts-circuits d'émetteur sont choisies pour atteindre les caractéristiques souhaitées du thyristor principal, notamment pour lui conférer un courant de maintien relativement élevé, ce qui implique une densité de trous de courts-circuits d'émetteur relativement élevée. Par contre, le thyristor amplificateur est exempt de trous de courts-circuits d'émetteur pour avoir une forte sensibilité de sorte que le thyristor à amplification de gâchette d'ensemble puisse être déclenché par un courant de gâchette faible.

L'homme de l'art saura trouver divers moyens pour assurer que la résistance à l'état passant du thyristor principal soit suffisante pour que, quand ce thyristor principal est en conduction, le thyristor amplificateur ne soit pas désamorcé. Il pourra en particulier jouer sur la distribution des trous de courts-circuits d'émetteur, sur les niveaux de dopage des régions N1 et P1, sur l'épaisseur de la région P1, ou sur la durée de vie des porteurs minoritaires dans la région P1 ou une portion de la région N2.

Dans un mode de réalisation de la présente invention correspondant à la figure 4, les concentrations de surface des dopants, CS, dans les diverses couches avaient les ordres de grandeur suivants :

$$CS_{N1} = CS_{N'1} = 10^{20} \text{ at./cm}^3,$$

$$CS_{P2} = CS_{P1} = CS_{P'1} = 10^{18} \text{ at./cm}^3,$$

$$CS_{P-} = 10^{15} \text{ at./cm}^3,$$

et la résistance de la couche N2 était de 30 à 60 ohm.cm selon la tension visée.

A titre d'exemple, dans une réalisation de la présente invention où le composant était similaire au composant TN22 susmentionné, on a obtenu des valeurs respectives de $I_H$ et de $I2_0$ de 300 et 200 milliampères ce qui permettait d'obtenir un thyristor à amplification de gâchette dont le courant de maintien équivalent était de l'ordre de 500 milliampères au lieu de 200 pour le composant classique. On pourra augmenter $I2_0$ en augmentant la tension négative appliquée à la gâchette du composant, une limite étant toutefois imposée par le souhait de réaliser une commande simple et par la puissance dissipée dans le circuit de gâchette. Par exemple, en appliquant -3 V au lieu de -2 V entre gâchette et cathode, $I2_0$ atteint une valeur de 300 mA au lieu de 200 mA.

Comme on l'a indiqué précédemment, une application du composant selon la présente invention réside dans les commutateurs associés à des ballasts de lampes à fluorescence. En particulier, le composant selon la présente invention peut remplacer le composant TN22 dans cette application.

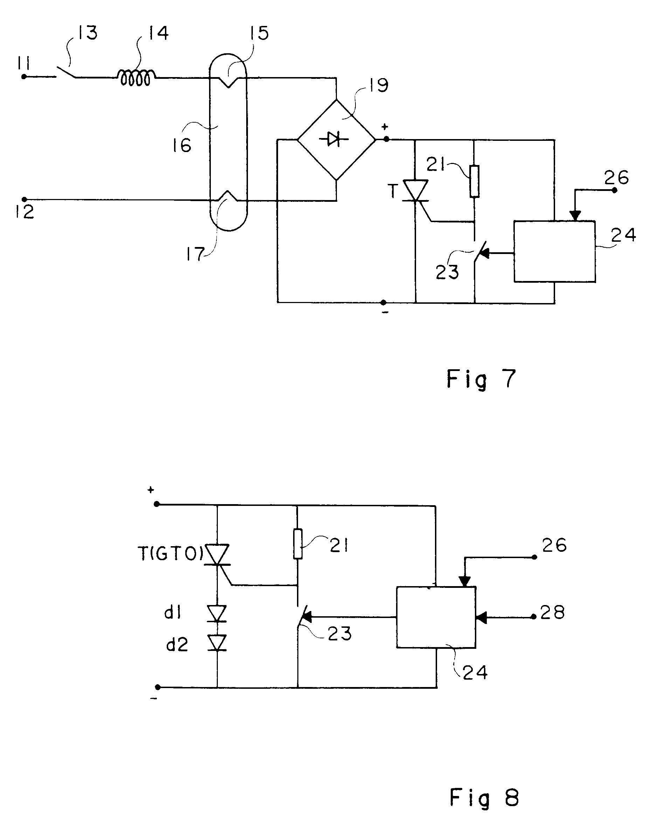

La figure 7 représente le schéma de commande d'une lampe à fluorescence tel qu'il apparaît dans la notice du composant TN22 publiée en novembre 1991 par SGS-Thomson Microelectronics. Une alimentation alternative, couramment 220 volts est appliquée entre des bornes 11 et 12. La borne 11 est connectée par l'intermédiaire d'un commutateur de mise sous tension 13 et d'un ballast inductif 14 à une première borne d'une résistance de chauffage 15 d'un tube à fluorescence 16. La borne 12 est connectée à la première borne d'une autre résistance de chauffage 17 du tube 16. Les deuxièmes bornes des résistances de chauffage 15 et 17 sont connectées aux entrées alternatives d'un pont redresseur 19. Les sorties (+) et (-) du pont redresseur 19 sont respectivement connectées à l'anode et à la cathode d'un thyristor T tel que le thyristor TN22 qui correspond au thyristor de la figure 1A de la présente demande. La gâchette du thyristor est connectée à la borne (+) par l'intermédiaire d'une résistance 21 et à la borne (-) par un interrupteur commandé 23. Un circuit de commande 24 de l'interrupteur 23 est également alimenté par les bornes (+) et (-) et reçoit sur une borne 26 un signal de commande déterminant l'ouverture ou la fermeture de l'interrupteur 23. Initialement, l'interrupteur 23 est ouvert et dès que l'interrupteur 13 est fermé, le thyristor T entre en conduction. Un courant de chauffage circule alors dans les résistances 15 et 17 du tube 16. Après une durée de préchauffage, l'interrupteur 23 est fermé par le circuit de commande 24 et le thyristor T s'ouvre dès que le courant qui le traverse chute en-dessous de son courant de maintien IH provoquant alors la génération d'une impulsion de déclenchement par le ballast inductif 14. L'impulsion fournie par le ballast inductif 14 a une amplitude qui dépend de la valeur du courant de maintien du thyristor T. Plus le courant de maintien sera élevé, plus cette impulsion sera forte. C'est pourquoi, on cherche à obtenir comme on l'a indiqué précédemment des courants de maintien de valeur élevée.

Comme le représente la figure 8, on propose d'utiliser le thyristor T(GTO) selon la présente invention pour remplacer le thyristor T de la figure 7. Le montage est sensiblement identique à celui de la figure 7 sauf que plusieurs diodes, d1, d2, sont disposées en série avec le thyristor T(GTO) et que le circuit de commande 24 reçoit une entrée de validation supplémentaire 28. Cette entrée de validation est active, c'est-à-dire que le circuit de commande 24 est susceptible de fermer l'interrupteur 23 seulement quand le courant dans le thyristor T(GTO) devient inférieur ou égal au courant $IH+I2_0$ susmentionné. Alors, si on ferme l'interrupteur 23, la cathode du thyristor T (GTO) est polarisée positivement par rapport à la gâchette, de la somme des chutes de tension en direct de chacune des diodes d1, d2 de la chaîne de diodes. Cette valeur dépendra du nombre de diodes utilisées.

Ainsi, la présente invention nécessite pour sa mise en oeuvre peu de modifications par rapport au circuit classique l'adjonction des diodes d1 et d2 et la prévision d'un circuit de détection de courant.

De préférence, on choisira d'insérer le composant selon la présente invention dans un montage tel que, pendant la période de préchauffage, le courant dans le transistor T(GTO) n'est pas susceptible de dépasser la valeur $IH+I2_0$. Alors, la prévision d'un circuit de détection de courant devient inutile. La zone d'amplification de gâchette pourra être une zone centrale du composant.

## Revendications

1. Thyristor à amplification de gâchette à courant de maintien élevé comprenant un thyristor principal et un thyristor amplificateur, caractérisé en ce que :

le thyristor amplificateur est du type à ouverture par la gâchette ;

le thyristor principal (T1) est de type classique, non ouvrable par la gâchette ; et

le thyristor principal (T1) et le thyristor amplificateur sont réalisés de sorte que le thyristor amplificateur soit en conduction tandis que le thyristor principal est normalement en conduction, le courant dans le thyristor amplificateur ayant une valeur déterminée ($I2_0$) quand le courant dans le thyristor principal (T1) est proche du courant de maintien ($I_H$) de celui-ci, et en ce qu'il comprend des moyens pour détecter le moment où le courant total dans le thyristor chute à une valeur sensiblement voisine de la sonne dudit courant de maintien et dudit courant de valeur déterminée et des moyens pour appliquer une tension de gâchette négative sur le thyristor à ouverture par la gâchette quand cette détection a été réalisée.

2. Thyristor selon la revendication 1, réalisé sous forma d'un composant monolithique dans lequel le thyristor principal et le thyristor amplificateur sont réalisés verticalement dans une structure semiconductrice.

3. Thyristor selon la revendication 2, caractérisé en ce que le thyristor principal et le thyristor amplificateur ont des niveaux de dopage d'émetteur et/ou de cathode distincts.

4. Application du thyristor selon la revendication 1, à un circuit d' allumage de lampe à fluorescence dans laquelle ce thyristor est connecté aux bornes continues d'un pont redresseur (19), en série avec une chaîne de diodes (d1, d2), avec une résistance (21) entre gâchette et anode et un interrupteur commandé (23) entre gâchette et cathode de la dernière diode de la chaîne de diodes, la valeur de la somme du courant de maintien (IH) du thyristor principal et du courant ($I2_0$) dans le thyristor amplificateur étant supérieure au courant dans le thyristor pendant la phase de préchauffage de la lampe à fluorescence.

**Claims**

1. An amplifying-gate thyristor including a main thyristor and an amplifying thyristor, characterized in that:

the amplifying thyristor is of the gate turnoff-type;
the main thyristor (T1) is of a conventional type that cannot be turned off by its gate; and
the main thyristor (T1) and the amplifying thyristor are such that the amplifying thyristor remains in the conductive state while the main thyristor is normally conductive, the current in the amplifying thyristor having a predetermined value ($I2_0$) when the current in the main thyristor (T1) is close to its hold current ($I_H$), and

in that it includes means for detecting the moment when the whole current in the thyristor drops to a value substantially equal to the sum of said hold current and of said current having a predetermined value, and means for applying a negative gate voltage to the gate turnoff thyristor once this detection has been carried out.

2. The thyristor of claim 1, manufactured as a monolithic component in which the main thyristor and the amplifying thyristor are vertically disposed in a semi-conductor structure.

3. The thyristor of claim 2, characterized in that the main thyristor and the amplifying thyristor have distinct emitter and/or cathode doping levels.

4. Application of the thyristor of claim 1 to a fluorescent lamp switching circuit, wherein said thyristor is connected to the d.c. terminals of a rectifying bridge (19), in series with a series of diodes (d1, d2), with a resistor (21) disposed between gate and anode, and a switch (23) controlled between the gate of the thyristor and the cathode of the last diode of the series of diodes, the value of the sum of the hold current ($I_H$) of the main thyristor and of the current ($I2_0$) in the amplifying thyristor being greater than the current in the thyristor during the preheating phase of the fluorescent lamp.

**Patentansprüche**

1. Thyristor mit Gate-Verstärkung (Gate-Verstärkungs-Thyristor) mit erhöhtem Haltestrom, umfassend einen Hauptthyristor und einen Verstärkerthyristor,
**dadurch gekennzeichnet,**

daß der Verstärkungsthyristor vom Typ mit Öffnung (Sperrung) durch das Gate ('gate turnoff') ist;

daß der Hauptthyristor (T1) vom herkömmlichen, nicht durch das Gate sperrbaren Typ ist; und

daß der Hauptthyristor (T1) und der Verstärkerthyristor derart ausgebildet sind, daß der Verstärkungsthyristor leitend ist, während der Hauptthyristor normalerweise leitend ist, wobei der Strom in dem Verstärkungsthyristor einen vorbestimmten Wert ($I2_0$) besitzt, wenn der Strom in dem Hauptthyristor (T1) nahe seinem Haltestrom ($I_H$) liegt; und

daß er Detektionsmittel aufweist zur Feststellung des Zeitpunkts, in dem der Gesamtstrom in dem Thyristor auf einen Wert im wesentlichen nahe der Summe aus dem genannten Haltestrom und dem genannten Strom vorbestimmten Werts abfällt, sowie Mittel zum Anlegen einer negativen Spannung an den durch das Gate sperrbaren Thyristor, sobald diese Feststellung erfolgt ist.

2. Thyristor nach Anspruch 1, in Ausbildung in Form eines monolithischen Bauteils, in welchem der Hauptthyristor und der Verstärkungsthyristor vertikal innerhalb einer Halbleiterstruktur realisiert sind.

3. Thyristor nach Anspruch 2, dadurch gekennzeichnet, daß der Haupt- und der Verstärkungsthyristor distinkte Emitter- und/oder Kathoden-Dotierungspegel aufweisen.

4. Anwendung des Thyristors nach Anspruch 1 in einer Zündschaltung für eine Fluoreszenz- bzw. Leuchtstofflampe, bei welcher dieser Thyristor mit den Gleichstromanschlüssen einer Gleichrichtbrücke (19) verbunden ist, in Reihe mit einer Diodenkette (d1,d2), mit einem Widerstand (21) zwischen Gate und Anode, und mit einem steuerbaren Schalter (23) zwischen Gate und der Kathode der letzten Diode der Diodenkette, wobei der Betrag der Summe aus dem Haltestrom ($I_H$) des Hauptthyristors und aus dem Strom ($I2_0$) in dem Verstärkerthyristor größer als der Strom in dem Thyristor während der Vorheizphase der Fluoreszenz- bzw. Leuchtstofflampe ist.

Fig IA

Fig IB

Fig 2A

Fig 2B

Fig 3

Fig 4

CCI

K

N1

P1

N2

M

$\ell$

N'1

P'1

G

P2

Fig 5

M

N'1

$\ell$

P'1

$\ell$

G

Fig 6

Fig 7

Fig 8